Europäisches Patentamt

(19) European Patent Office (11) Publication number: **0 023 925**

Office européen des brevets **B1**

(12) **EUROPEAN PATENT SPECIFICATION**

(45) Date of publication of patent specification: **10.07.85** (51) Int. Cl.⁴: **H 01 L 21/318**

(21) Application number: **79900248.0**

(22) Date of filing: **19.02.79**

(86) International application number:
**PCT/JP79/00039**

(87) International publication number:
**WO 80/01739 21.08.80 Gazette 80/19**

(54) **METHOD OF PRODUCING INSULATING FILM FOR SEMICONDUCTOR SURFACES AND SEMICONDUCTOR DEVICE WITH SUCH FILM.**

(43) Date of publication of application:
**18.02.81 Bulletin 81/07**

(45) Publication of the grant of the patent:
**10.07.85 Bulletin 85/28**

(84) Designated Contracting States:
**DE FR GB**

(56) References cited:
**DE-A-1 696 625**
**JP-A-51 105 270**
**JP-A-54 019 663**
**JP-A-54 021 264**
**JP-A-54 023 378**

**Journal of the Electrochemical Society vol. 125, No. 11, (1978-11), David Hackleman, et al "A Simple Technique for Silicon Nitride Growth", See pages 1875 to 1876**
**Journal of the Electrochemical Society vol. 125, No. 3, (1978-3), T. Ito, et al "Very Thin Silicon Nitride Films Growth by Direct Thermal Reaction with Nitrogen", See pages 448 to 452**

(73) Proprietor: **FUJITSU LIMITED**
**1015, Kamikodanaka Nakahara-ku**
**Kawasaki-shi Kanagawa 211 (JP)**

(72) Inventor: **NOZAKI, Takao**
**22-9, Chigusadai Midori-ku**
**Yokohama-shi Kanagawa 227 (JP)**
Inventor: **ITO, Takashi**
**408, Noborito Tama-ku**
**Kawasaki-shi Kanagawa 214 (JP)**

(74) Representative: **Muir, Ian R. et al**
**HASELTINE LAKE & CO. Hazlitt House 28**
**Southampton Buildings Chancery Lane**
**London WC2A 1AT (GB)**

## Description

The present invention relates to a method of forming a stable and dense insulation film on a surface of a semi-conductor device, especially an integrated circuit.

With the aim of minimizing ageing variation of the characteristics of and of improving the reliability of manufacture of semi-conductor devices, it is common for an area where a pn junction is exposed on the surface of semi-conductor device, to be covered with an insulating film. In the MISFET and the MIS integrated circuits, a gate over an insulating film is provided for activating an inverting layer channel, and therefore, in this case, a particularly stable characteristic is required for the insulation layer. Usually, in such cases, the semi-conductor used is Si with $SiO_2$ as the insulating film and Al as the metal. However, such a structure has the disadvantage that the gate threshold voltage varies largely when an electrical field of about $10^6$ V/cm is applied to the insulating film at a temperature of 200°C. This phenomenon seems to arise as a result of variation in the space charge distribution at the interface because there are trapping levels of carrier due to structural defects in the $SiO_2$ layer and to drift of impurity ions migrating into the $SiO_2$.

It is obvious that the effects of such variation of space charge due to the structural defects at the interface of the Si and insulating film are most significant. For this reason, various coating techniques such as the vapor growth method, sputtering etc., have been tried in place of thermal oxide $SiO_2$ which readily allows mingling of ions such as alkali ions, but defects at the interface by these techniques were not reduced over those with thermal oxide $SiO_2$. On the other hand, the thermal oxide $SiO_2$ produced in a very clean ambient is kept in such a defect of $10^{11}/cm^2$ in terms of the surface charge density but still there is a defect such as excessive silicon ion etc. at the interface. This is a serious problem.

The present invention seeks to provide a method for solving such problems in the insulating film formed at the semi-conductor surface and, particularly, relates to a novel method of forming a homogeneous silicon nitride film having a satisfactorily high density structure directly on the surface of a Si substrate. It is a known fact that nitriding of the surface directly occurs when a Si substrate is heated in a nitrogen or ammonia ambient atmosphere but, according to prior report, it is considered difficult to obtain homogeneous amorphous $Si_3N_4$.

The inventors of the present invention believe to have found the causes for this. Namely, when a natural oxide film or impurity particle is adhered to the Si substrate, the $Si_3N_4$ is crystallized with such substance forming a nucleus and the layer growth or local nitriding proceeds unhomogeneously.

It is also found that in the case where the Si surface is clean, oxidation occurs as well as the nitriding because of $O_2$ and $H_2O$ contained in the nitridation ambient and, resulting, the growth of homogeneous $Si_3N_4$ is blocked. Therefore, the inventors of this invention previously proposed that the contents of $O_2$ and $H_2O$ in the nitrogen gas used for growing homogeneous and stable film should be kept at 1 ppm or less; such a purity will hereinafter be referred to as "a clean nitrogen ambient atmosphere".

According to the present invention there is provided a method of forming a silicon nitride insulating film on a silicon semi-conductor surface wherein the silicon nitride film is formed by directly nitriding the silicon semi-conductor surface characterised in that the nitriding includes two stages, a first nitriding stage using a clean nitrogen ambient atmosphere which substantially determines the final thickness of the nitride film and a second nitriding stage using an ambient atmosphere of ammonia gas or a mixture of ammonia gas and an inert gas which results in the nitriding of silicon existing in the nitride film after completion of the first stage.

The $Si_3N_4$ film formed in this way may be more minute in structure and of more easily controlled film thickness than a $Si_3N_4$ film which is formed by directly nitriding a Si substrate using a single gas nitriding stage of nitrogen gas, ammonia gas or a mixed gas including ammonia as the reaction gas.

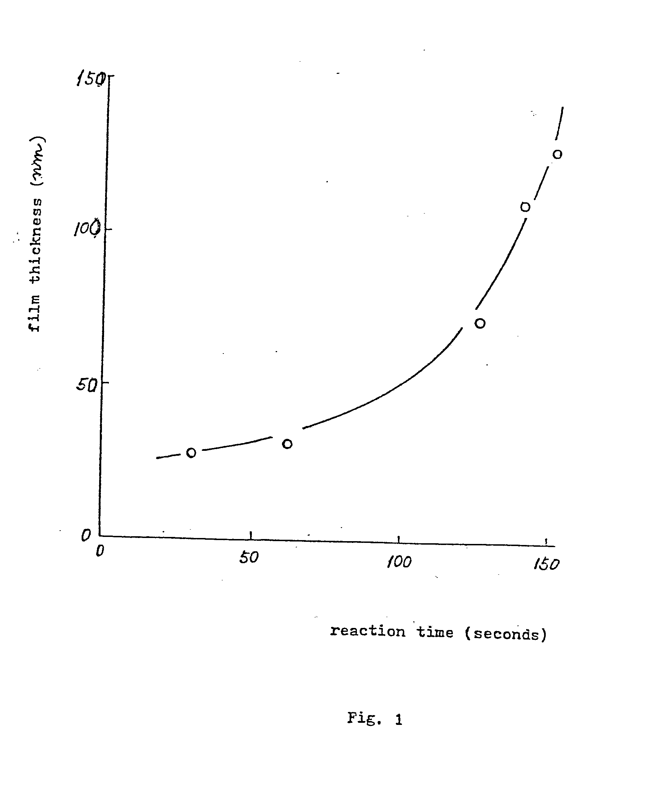

For a better understanding of the present invention reference will now be made, by way of example, to the accompanying drawings in which Fig. 1 shows the relation between the reaction time and the $Si_3N_4$ film thickness obtained by a direct nitriding method using solely nitrogen gas;

Fig. 2 shows the relation between the reaction time and the $Si_3N_4$ film thickness in a direct nitriding method using ammonia gas;

Fig. 3 shows the relation between the direct thermal oxidation processing time and silicon oxide film thickness;

Fig. 4 shows a block schematic diagram of apparatus for carrying out a method in accordance with this invention.

As can be seen from Fig. 1, when direct nitriding is performed in an ambient atmosphere of only nitrogen gas, a $Si_3N_4$ film having a thickness of about 15 nm (150 Å) can be formed within a period as short as 150 seconds. However, the refractive index of the $Si_3N_4$ film formed in this manner is often as large as 2.3 compared with refractive index 1.95 of the idal $Si_3N_4$. This means that Si is contained in the $Si_3N_4$ film formed by direct nitriding in a nitrogen gas atmosphere.

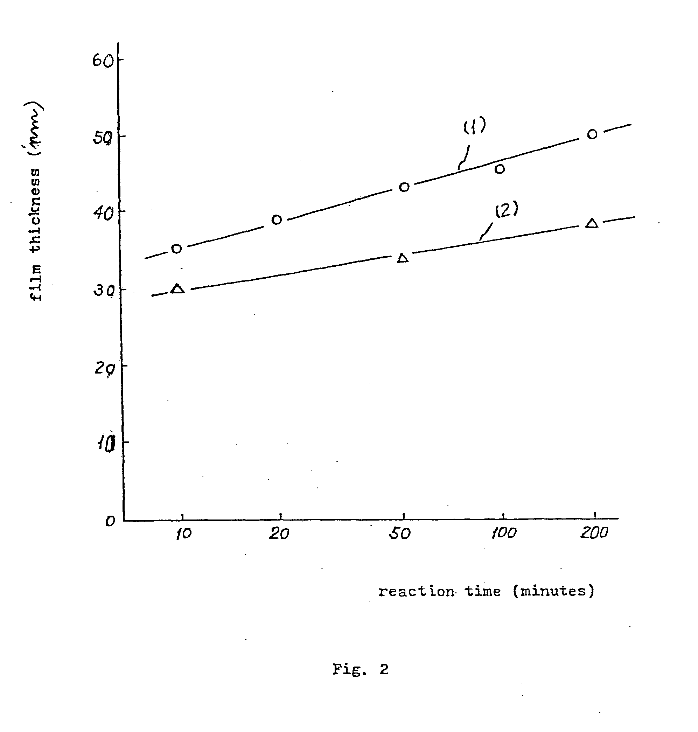

On the other hand, as can be seen from Fig. 2, in a direct nitriding method using ammonia gas or a mixed gas, with an inert gas containing the ammonia gas as the reaction gas, the $Si_3N_4$ film is as thin as 5 nm (50 Å) even if the reaction time is as long as 200 minutes. For the characteristic of Fig. 2 (1), the reaction temperature is 1300°C, while for Fig. 2 (2), the reaction temperature is 1100°C and a 100% ammonia gas is used as the ambient atmosphere.

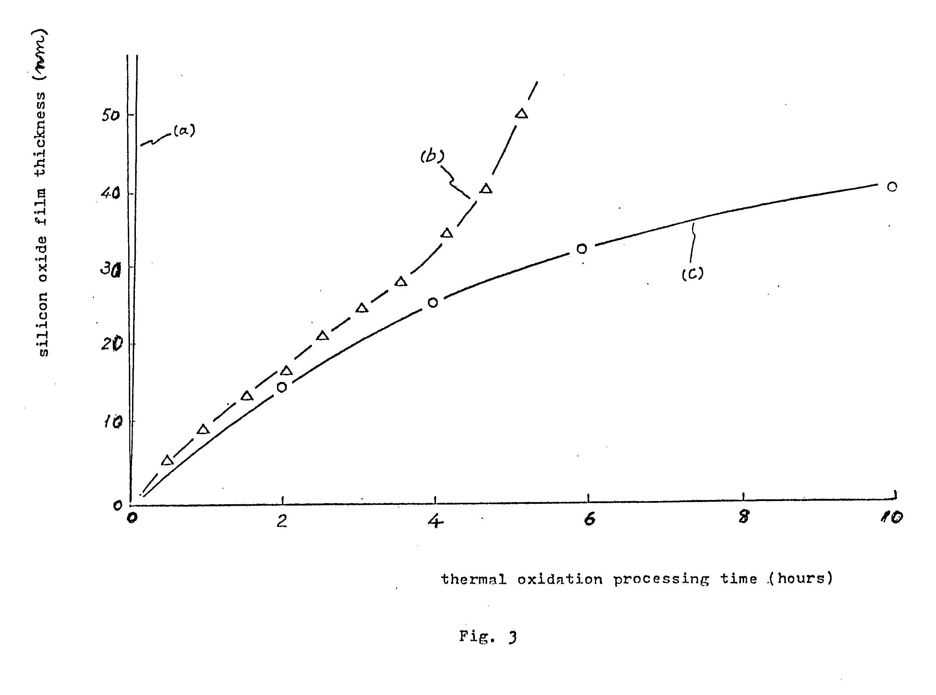

Fig. 3 shows the relation between the oxidation time and thickness of a silicon oxide film when a silicon substrate (a) having an exposed surface (b) having a silicon nitride film with a thickness of 7.5 nm (75 Å) formed on the silicon substrate surface in a nitrogen gas atmosphere and (c) having a silicon nitride film with a thickness of 4 nm (40 Å) formed on the substrate in an ammonia gas, is directly subjected to thermal oxidation in a dry oxygen gas at a temperature 1010 °C. The symbols (a), (b) and (c) in Fig. 3 identify the characteristics corresponding respectively to the above substrates (a), (b) and (c).

As is clear from Fig. 3, in the case of the silicon substrate (b), growth rate of the silicon oxide is fast and the masking ability of the nitride layer for the oxygen is lost after a thermal oxidation process of about 5 hours, whilst in case of the silicon substrate (c), the growth rate of the silicon oxide film is slow and the masking ability of the nitride layer for the oxygen is not lost even after a thermal oxidation process of as long as 10 hours. Thus, it can be seen that the silicon nitride film generated in an ammonia gas ambient atmosphere is more dense than the silicon nitride film produced in a nitrogen atmosphere. Moreover, although not shown, it has been found that even when silicon substrate is directly nitrided thermally in an ammonia gas ambient atmosphere and then subjected to thermal processing in a nitrogen gas ambient atmosphere, increase of thickness of the silicon nitride layer cannot be observed. It can, therefore, be concluded that diffusion of nitrogen is rate-determined because of the dense structure of the silicon nitride produced in the ammonia gas ambient atmosphere.

The method of forming the silicon nitride film according to this invention makes use of the fact that a thick $Si_3N_4$ film is generated in the direct nitriding method where nitrogen gas is used as the reaction gas and formation of a thick silicon nitride is difficult but a dense film can be generated in the direct nitriding method where ammonia gas or a mixed gas, with inert gas containing ammonia, is used as the reaction gas.

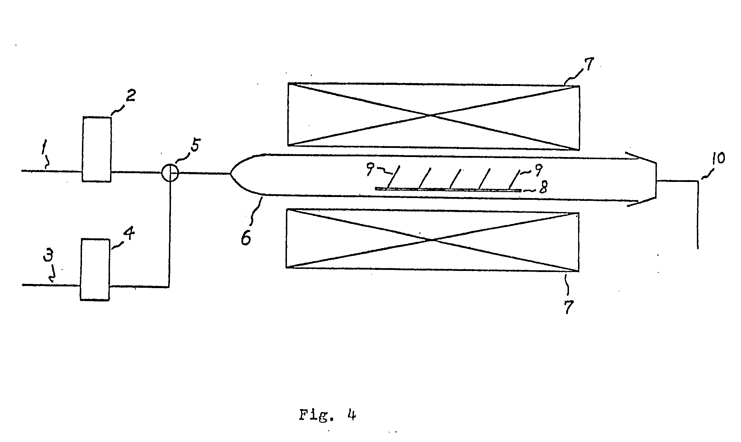

Fig. 4 shows general view of an apparatus for carrying out this invention. In this figure, 1 is a source of nitrogen gas; 2 is a nitrogen gas refining a cleaning system using a catalyst; 3 is a source of ammonia gas or of a mixed gas, with inert gas containing ammonia; 4 is an ammonia gas refining system using a catalyst; 5 is a changeover valve; 6 is a reaction tube; 7 is an electric furnace; 8 is a silicon wafer holder; 9 are silicon wafers; and 10 is a gas exhaust port.

The method of producing the insulating film using this apparatus is as follows. Si substrates 9, of which the surface is previously sufficiently cleaned, are inserted in their holder 8 into the equally heated area of the reaction tube 6.

In the reaction tube 6, clean nitrogen gas 1 is flowing at a rate of 5 l/min. Upon completion of nitriding of a constant amount of the nitrogen gas, then nitriding is performed by changing the reaction gas in the reaction tube 6 from the nitrogen gas to ammonia gas or to an inert gas 3 containing the ammonia gas.

What is intended by this method is that the silicon contained in the silicon nitride film, formed on the silicon substrate by nitriding by the nitrogen gas, is nitrided in the ammonia gas atmosphere or in the mixed gas atmosphere of an inert gas including ammonia gas. The silicon nitride film obtained thereby is equivalent in film thickness to the silicon nitride obtained by nitriding in the nitrogen gas but is excellent in its impurity diffusion mask ability and selective oxidation mask ability because of its dense structure and makes possible the manufacture of semi-conductor device with stable electrical characteristic when the method is employed for the gate insulating film of an MISFET.

## Claims

1. A method of forming a silicon nitride insulating film of a silicon semi-conductor surface wherein the silicon nitride film is formed by directly nitriding the silicon semi-conductor surface, characterised in that the nitriding includes two stages, a first nitriding stage using a clean nitrogen ambient atmosphere which substantially determines the final thickness of the nitride film and a second nitriding stage using an ambient atmosphere of ammonia gas or a mixture of ammonia gas and an inert gas which results in the nitriding of silicon existing in the nitride film after completion of the first stage.

2. A semi-conductor device with a silicon nitride insulating film formed by the method of claim 1.

## Patentansprüche

1. Verfahren zur Herstellung eines isolierenden Siliziumnitridfilms auf einer Siliziumhalbleiteroberfläche, bei welchem der Siliziumnitridfilm durch direktes Nitrieren der Siliziumhalbleiteroberfläche gebildet wird, dadurch gekennzeichnet, daß das Nitrieren zwei Stufen umfaßt, eine erste Nitrierstufe, welche eine saubere Stickstoffumgebungsatmosphäre verwendet, die im wesentlichen die endgültige Dicke des Nitridfilms bestimmte, und eine zweite Nitrierstufe, welche eine Umgebungsatmosphäre aus Ammoniakgas oder einer Mischung aus Ammoniakgas und einem inerten Gas umfaßt, was, nach Beendigung der ersten Stufe, zu einer Nitrierung des in dem Nitridfilm bestehenden Siliziums führt.

2. Halbleitervorrichtung mit einem isolierenden Siliziumnitridfilm, der durch das Verfahren nach Anspruch 1 gebildet ist.

## Revendications

1. Un procédé de formation d'une pellicule isolante en nitrure de silicium à la surface d'un demi-conducteur de silicium, où la pellicule en nitrure de silicium est formée par nitruration directe de la surface semi-conductrice de silicium, caractérisé en ce que la nitruration comporte deux étapes, une première étape de nitruration utilisant l'atmosphère ambiante d'azote propre qui détermine sensiblement l'épaisseur finale de la pellicule de nitrure, et une deuxième étape de nitruration utilisant une atmosphère ambiante d'ammoniac gazeux, ou d'un mélange d'ammoniac gazeux et d'un gaz inerte, qui produit la nitruration du silicium existant dans la pellicule de nitrure après l'achèvement de la première étape.

2. Dispositif semi-conducteur comportant une pellicule isolante en nitrure de silicium formée par le procédé de la revendication 1.

Fig. 1

Fig. 2

Fig. 3

0 023 925

Fig. 4